Europäisches Patentamt

European Patent Office

Office européen des brevets

(11) Publication number: **0 279 906 B1**

(12) **EUROPEAN PATENT SPECIFICATION**

(45) Date of publication of patent specification: **06.05.92**     (51) Int. Cl.⁵: **H05K 7/14**, G06F 13/40

(21) Application number: **87115180.9**

(22) Date of filing: **16.10.87**

(54) **Adapter card mounting in a low profile microcomputer.**

(30) Priority: **26.02.87 US 19455**

(43) Date of publication of application:
**31.08.88 Bulletin 88/35**

(45) Publication of the grant of the patent:
**06.05.92 Bulletin 92/19**

(84) Designated Contracting States:
**AT BE CH DE ES FR GB GR IT LI LU NL SE**

(56) References cited:
**EP-A- 0 117 954**
**FR-A- 2 114 169**
**US-A- 3 675 083**

**E.D.N. ELECTRICAL DESIGN NEWS, vol. 32,
no. 4, 19th February 1987, pages 114-126,
Newton, MA, US; "Industrial buses",**

(73) Proprietor: **International Business Machines
Corporation
Old Orchard Road
Armonk, N.Y. 10504(US)**

(72) Inventor: **Ansell, Daniel Frederick
4100 NW 107th Avenue
Coral Springs Florida 33065(US)**
Inventor: **Harris, James Coleman
1111 SW 15th Street
Boca Raton Florida 33432(US)**
Inventor: **Howell, Steven Ernest
7375 Sunny Hill Terrace
Lantana Florida 33462(US)**
Inventor: **Miller, Michael Sven
2520 Mallard Drive
Delray Beach Florida 33444(US)**
Inventor: **Wysong, Robert D.
4250 NW 26th Avenue
Boca Raton Florida 33434(US)**

(74) Representative: **Killgren, Neil Arthur et al
IBM United Kingdom Limited Intellectual
Property Department Hursley Park
Winchester Hampshire SO21 2JN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.08/2.18/2.0)

**Description**

The present invention relates to mounting adapter cards used for, for example, communication facilities, in a low profile microcomputer, or in other words a microcomputer having a relatively low height dimension.

With the exception of some of the lowest price small systems, all microcomputers include means for mounting and connecting adapter cards. Such cards include those employed for communications, i.e. internal modems, those used to drive displays, to couple keyboards and to provide memory expansion. In most systems these cards are mounted vertically. Normally the microcomputer planar board, which contains most of the processing components, carries a plurality of sockets which extend upwardly from the planar board. Each adapter card has a plug portion which fits into a socket to connect the card to the planar and partially support it in position. Normally each card also has a metal bracket mounted at its rear end. This bracket, on which may be mounted plugs or sockets for connection of external devices to the card, is normally secured to the rear surface of the microcomputer to further support the card and to prevent its displacement when a plug or socket is coupled to a bracket mounted device.

In the art, a number of systems in which a plurality of adapter cards plug into a common extender and have been shown. An example of such a system is shown in U. S. Patent No. 3,675,083 (White). In this system, an extender connector system has sockets for receiving and coupling a plurality of cards. The cards are plugged into the extender by means of plug connections on the rear ends of the cards. The cards, when coupled to the extender connection system are positioned in parallel with each other vertically. With reduction in the size of microcomputers, and in particular reduction in height, a problem arises when it is desired to accommodate adapter cards developed for original use in a prior machine. It is, of course, desirable to minimize cost to a user when he migrates from one machine to a later one. One way in which this can be achieved is to allow him to use the same adapter cards. If, however the adapter card width is greater than the height of the new system, the cards can not be mounted vertically.

It is, therefore, an object of the invention to provide means for mounting adapter cards horizontally in a low profile microcomputer system.

In accordance with the invention, there is provided a microcomputer system including means for mounting optional adapter cards, said means comprising first socket means connected to and supported by a horizontal planar board carrying components of the microcomputer, characterised by:

an extender card pluggable into and supportable by said first socket means, to extend vertically from said planar board and carrying a plurality of second socket means, each second socket means being adapted to accept an edge connector of a horizontally positioned adapter card;

bridge means removably mounted between the top of said extender card and a vertical wall of the microcomputer for minimizing horizontal movement of said extender card; and

support means removably mounted in a slot in a vertical wall of the microcomputer for slidable movement into engagement with an end of a horizontally positioned adapter card, said support means having a channelled arm for enclosing and supporting said end of an adapter card.

A prefered embodiment of the invention will now be described by way of example with reference to the accompanying drawings, in which:

Figure 1 is a top view of a microcomputer system partially broken away, and with the top cover removed;.

Figure 2 is a diagram showing a perspective view of an extender card shown in Figure 1 and a support bridge for the extender card;.

Figure 3 is a perspective view of an adapter card support member showing slots in a vertical wall in the microcomputer of Figure 1 into which the member can be fitted;.

Figure 4 is a detailed side view of the support member of Figure 3; and

Figure 5 is a detailed bottom view of the support member of Figure 3.

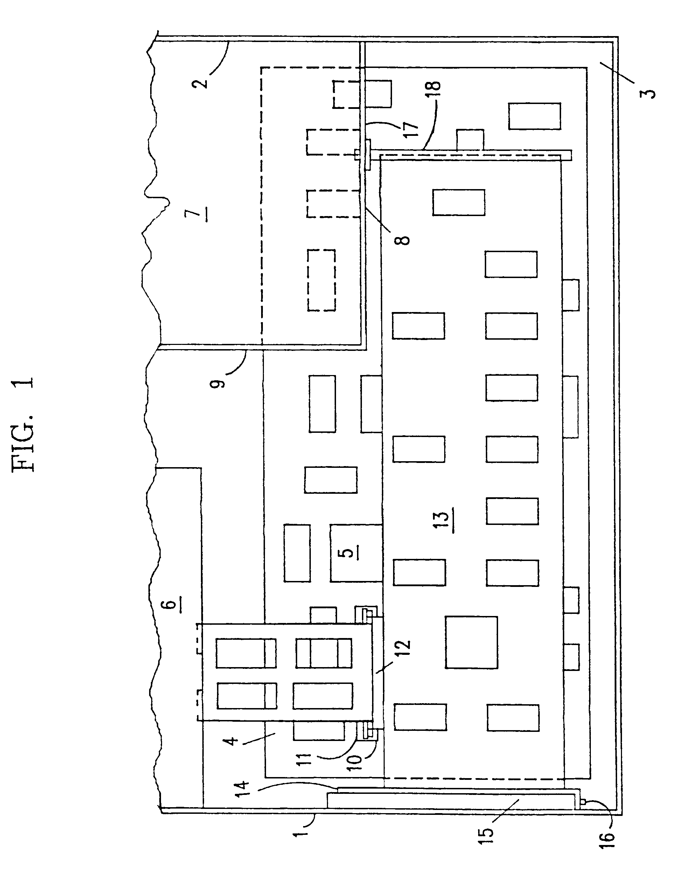

Referring to Figure 1, there is shown therein a microcomputer system having a rear wall 1, a front wall 2 and a floor 3. A planar board 4 is mounted on floor 3 and carries electronic components of the microcomputer, such as a microprocessor 5. These components are soldered to printed wiring carried by planar board 4. An enclosed power supply 6 is mounted to floor 3 and rear wall 1. A tray including a side wall 8 a rear wall 9 and a floor 7 is mounted to front wall 2. This tray does not extend down to floor 3, and its floor 7 extends over and above part of planar board 4 as shown. The tray is adapted to receive and support removable components, such as disk drive memories, placed thereon through a suitable aperture (not shown) in the front panel.

Planar board 4 carries a socket 10 which is soldered to the board wiring and extends upwardly from the board. This socket is designed to accept an edge connector of an extender card 11 such that, when in place in the socket, the extender card stands vertically from the planar board. The extender card carries a plurality of sockets, such as socket 12, each of which extends normally from the card surface. Each socket is adapted to accept an edge connector of an adapter board, such as board 13, so that each board, when so engaged, extends outwardly from the extender card and horizontally parallel to planar board 4 as shown. At the rear end of the adapter card, there is mounted a metal bracket 14 which covers a part 15 and is secured to this part by a screw 16. This arrangement of coupling to a part is identical to that employed in the Personal Computer manufactured by International Business Machines Corporation, except that the part is horizontal rather than vertical.

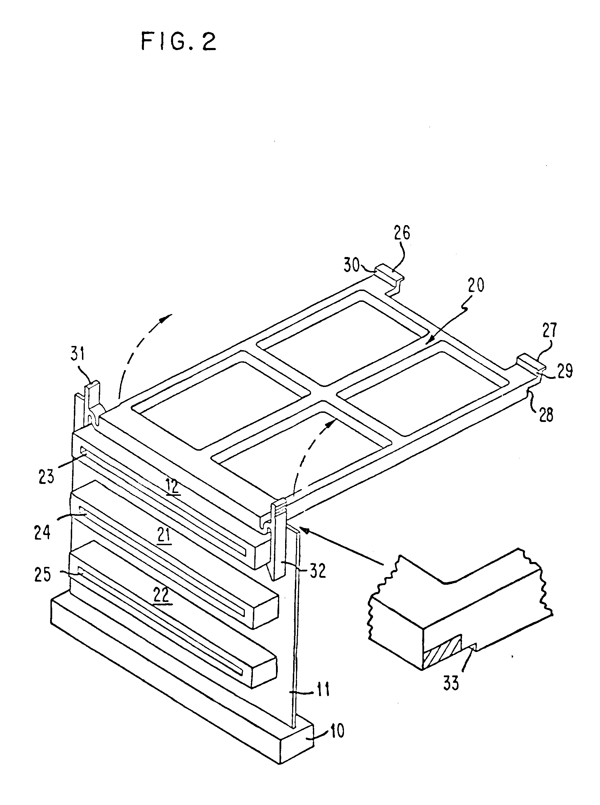

Figure 2 shows the extender card arrangement and a magnified detail of a corner of a support bridge 20. As can be seen in this figure, extender card 17 plugs into, and is supported by, socket 10, which, as has been previously explained, is soldered to the planar board. The extender card carries three sockets 12, 21 and 22 each of which carries a plurality of socket connections (not shown) in respective slots 23 through 25. These slots and connectors are arranged to accept edge connections on adapter cards. When plugged into a socket, an adapter card is coupled to the data, address, and control busses of the planar through the socket, wiring on the extender card 11 and finally through socket 10.

In order to prevent horizontal movement of extender card 11, support bridge 20 is provided to support the top of the extender card against such movement. Bridge 20 includes, at one end, tab portions 26 and 27 adapted to pass through apertures in the wall of power supply 6 as shown in Figure 1. These apertures, which are not shown, are rectangular in shape, and the wall thickness of the power supply is such that, with the bridge in the position shown in Figure 2, the tabs 26 and 27 are a snug fit in the apertures with surface 28, which extends right across the bridge, engaging the outside of the power supply wall and with surfaces 29 and 30 engaging the inside surface of this wall. The bridge is placed into the power supply wall apertures by placing the outwardly extending portions of the tabs into the apertures, then swinging the bridge in the direction of the curved arrows, and then returning it to the Figure 2 position.

At the end of bridge 20 opposite tabs 26 and 27, grippers 31 and 32 are formed. Each of these grippers comprises an arm having a upper portion above and a lower portion below, a serpentine spring section coupling the arm to the main body of the bridge. The bridge is a one-piece plastic molding, and the serpentine sections are of a dimension such that, with the plastic material utilized, the arms can be pivoted about the junction of the spring portion and the main body. At the lower end of each gripper, and as shown on gripper 32, there is a horizontal surface under which a sloping surface continues to the end of the lower arm portion.

This horizontal surface is adapted to engage the under surface of socket 12 when bridge 20 is in position as shown. To remove the bridge from extenders card 11, the serrated portions of the upper portions of the gripper arms are squeezed manually so that the grippers pivot away from the ends of socket 12. The bridge can then be moved in the direction of the dotted arrows. This removability is useful if, for example, it is required to inspect some part of the planar board (Figure 1) in the vicinity below the bridge. When it is again required to place the bridge in its operative position, the direction of the phantom arrows is reversed and the grippers 31 and 32 latch over the socket 12. The enlarged inset drawing in Figure 2 shows the corner of bridge 20 adjacent gripper 32. This gripper and its serpentine spring portion have been cut away from the inset drawing. What this drawing shows is a ledge 33 formed in the bridge. This ledge passes right across the bridge under the forward arm thereof. The ledge engages the rear surface of extender card 11 when bridge 20 is in its operative position. The extender card is, therefore, held between the ledge and rear faces of grippers 31 and 32 to prevent vertical movement thereof.

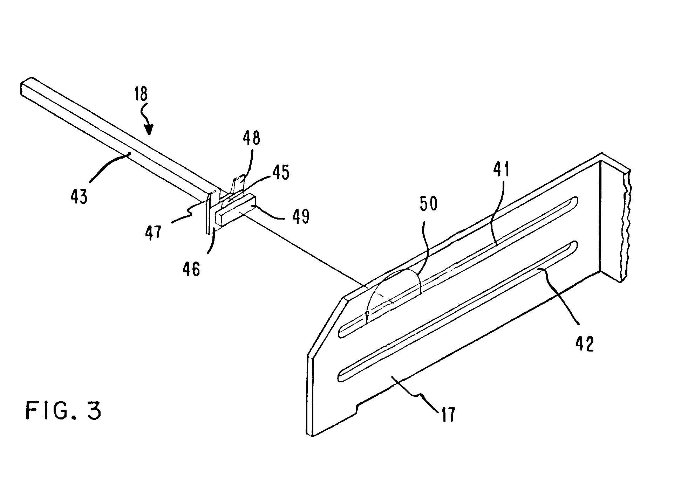

Figures 3 through 5 show details of a device for supporting the end of an adapter card adjacent the front of the microcomputer of Figure 1. This device comprises an arm which engages the end of the adapter card and is slidably fitted in a side wall 17 of tray 7. As can be seen in Figure 3, side wall 17 has slots 41 and 42 formed therein. It is noted that while the extender card has three sockets for supporting three adapter cards, only two slots for two such cards are provided in wall 17. This is because firstly, in this particular embodiment, tray 7 (Figure 1) is spaced above planar 4 at a distance such that there can be no corresponding slot in side wall 17 and secondly, many adapter cards are full length and can be supported by known fixtures at the front wall 2 of the microcomputer. Accordingly, the lowest adapter card, i.e. that fitting into socket 22 (Figure 2), should be a full length card.

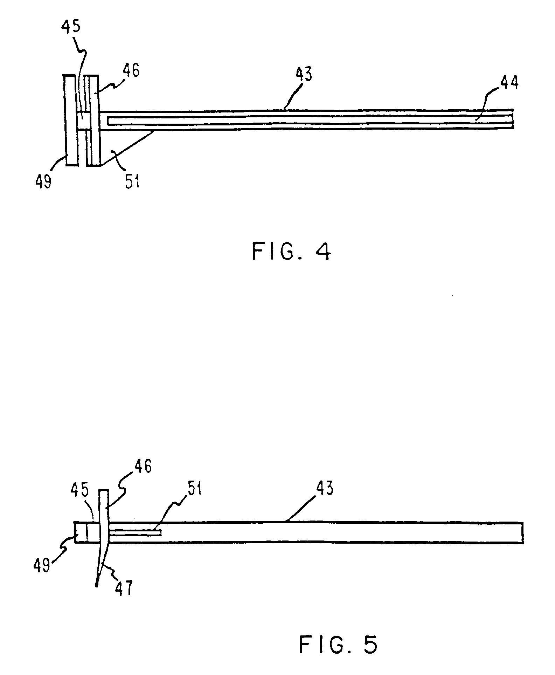

Referring now to Figure 3 through 5 in detail, the adapter arm 18 comprises an arm 43 having a channel 44 formed therein. This channel is dimensioned to engage and snugly fit an end of an adapter card as shown in Figure 1. Arm 43 has a rounded extension 45 at the ends of which are spaced a flat platform 46 having extended ears 47 and 48 and rectangular cross sectioned bar 49. The diameter of rounded extension 45 is such as to fit into one of the slots 41 and 42 and its length is such as to fit easily into the slot. As can be seen in Figure 3, in operation bar 49 is pushed through a slot and then adapter arm 18 is turned in a counter-clockwise direction as indicated by arrow 50. Bar 49 and platform 46 then sandwich a position of wall 17 to retain arm 18 on the wall. When the arm is in position on the wall, ears 47 and 48 take up any slack but permit sliding movement of the adapter arm along the slot. It is noted, particularly from Figures 3 and 5, that ears 47 and 48 reduce in thickness from the end attached to platform to the free end. This gives them sufficient flexibility to act as springs, and, as they slope away from arm 43 they provide spring pressure pulling bar 49 towards the wall. In addition, it can be seen that the ears are on the side of platform 46 away from the opening of channel 44 in arm 43. Thus, when the adapter arm is fitted to wall 17 and slid towards and into contact with the end of an adapter card, the spring effect of ears 47 and 48 tend to push arm 43 into close contact with the adapter card. Lastly, a filet 51 (Figures 4 and 5, but hidden in Figure 3), filling in a corner between arm 43 and platform 46, serves to strengthen and increase the rigidity of the integrated platform 46/arm 43 structure.

In summary, what has been disclosed is means for mounting adapter cards horizontally in a low profile microcomputer. The cards are coupled to the planar board of the microcomputer through a vertical extender card which is supported against vertical movement by a removable bridge coupled between the top of the extender card and a vertical wall in the microcomputer. One end of a card which is not sufficiently long to extend between the front and rear walls of the microcomputer is supported by a removable adapter arm. This arm has a channel which is dimensioned to engage the end of the card. It is slidably supported in a slot in a further vertical wall of the microcomputer.

**Claims**

1. A microcomputer system including means for mounting optional adapter cards (13), said means comprising first socket means (10) connected to and supported by a horizontal planar board (4) carrying components (5) of the microcomputer, comprising:

an extender card (11) pluggable into and supportable by said first socket means (10), to extend vertically from said planar board (4) and carrying a plurality of second socket means (23,24,25), each second socket means being adapted to accept an edge connector of a horizontally positioned adapter card (13);

bridge means (20) removably mounted between the top of said extender card (11) and a vertical wall of the microcomputer for minimizing horizontal movement of said extender card (11); and

support means (18) removably mounted in a slot (41,42) in a vertical wall (17) of the microcomputer for slidable movement into engagement with an end of a horizontally positioned adapter card (13), said support means (18) having a channelled arm (43) for enclosing and supporting said end of an adapter card (13).

2. A microcomputer system according to Claim 1 in which said support means (18) includes a platform (46) mounted at, and normal to, one end of said channelled arm (43), a circular cross-section extension (45) mounted from the platform (46) co-axially with said channelled arm (43), and a bar (49) mounted at right angles to, and at the end of, said extension (45), the diameter of the extension (45) and width of the bar (49) being substantially that of the width of said slots (41,42), and the length of the bar (49) being substantially greater than the width of said slots (41,42), and the length of said extension (45) being substantially that of the thickness of the vertical wall (17) defining the slots (41,42).

3. A microcomputer according to Claim 2, including ear elements (47,48) mounted on said platform (46), said ear elements (47,48) for applying spring pressure to said vertical wall (17) supporting said channelled arm (43) between said platform (46) and said bar (49).

4. A microcomputer system according to any of Claims 1 to 3 in which said bridge means (20), at one end thereof, includes means (26,27) for removably engaging at least one slot in said vertical wall and, at the opposite end thereof, means (31,32) for removably engaging the uppermost one of said second socket means (12) in an extender card (11) in said first socket means (10).

5. A microcomputer system according to Claim 4 in which said means (26,27) for removably engaging the uppermost one of said second socket means (12) comprises first and second means (31,32) for engaging first and second ends of said uppermost socket means (12), said first and second means (31,32) being resiliently attached to the body of said bridge means (20).

6. A microcomputer system according to any of Claims 1 to 5 in which said first and second means (31,32) for engaging comprise latch means each having a sloping surface for initial engagement with the uppermost socket and means (12) conforming with the profile of the uppermost socket for final locking engagement therewith.

7. A microcomputer system according to any of Claims 1 to 6 in which said body of the bridge (20) includes a step (33) adjacent said latch means (31,32) for engaging said extender card (11) between an edge of said latch means (31,32) and said step (33).

**Revendications**

1. Système de micro-ordinateur comportant des moyens pour monter des cartes d'adaptation optionnelles (13), lesdits moyens comprenant des premiers moyens de connecteur femelle (10) connectés à et supportés par une carte plane horizontale (4) supportant les composants (5) du micro-ordinateur, comprenant :

   une carte d'extension (11) que l'on peut enficher dans et qui peut être supportée par lesdits premiers moyens de connecteur femelle (10), pour s'étendre verticalement à partir de la carte plane (4) et supporter une pluralité de seconds moyens de connecteur femelle (23, 24, 25), chaque second moyen de connecteur femelle étant prévu pour accepter un connecteur de bord d'une carte d'adaptation horizontalement positionnée (13) ;

   des moyens de raccord (20) montés de manière amovible entre le sommet de ladite carte d'extension (11) et une paroi verticale du micro-ordinateur pour minimaliser le déplacement horizontal de ladite carte d'extension (11), et

   des moyens de support (13) montés de manière amovible dans une fente (41, 42) dans une paroi verticale (17) du micro-ordinateur pour déplacement coulissant en engagement avec une extrémité d'une carte d'adaptation horizontalement positionée (13), lesdits moyens de support (18) comportant un bras rainuré (43) pour enfermer et supporter ladite extrémité d'une carte d'adaptation (13).

2. Système de micro-ordinateur selon la revendication 1, dans lequel lesdits moyens de support (18) comportent une plate-forme (46) montée à et perpendiculaire à une extrémité dudit bras rainuré (43), un prolongement circulaire en section transversale (35) monté à partir de la plate-forme (46) coaxialement audit bras rainuré (43) et une barre (49) montée à angle droit et à l'extrémité dudit prolongement (45), le diamètre du prolongement (45) et la largeur de la barre (49) étant pratiquement ceux de la largeur desdites fentes (41, 42) et la longueur de la barre (49) étant nettement supérieure à la largeur desdites fentes (41, 42) et la longueur dudit prolongement (45) étant pratiquement celle de l'épaisseur de la paroi verticale (17) définissant les fentes (41, 42).

3. Micro-ordinateur selon la revendication 2, comportant des éléments de patte (47, 48) montés sur ladite plate-forme (46), lesdits éléments de patte (47, 48) servant à appliquer une pression de ressort à ladite paroi verticale (17) supportant ledit bras rainuré (43) entre ladite plate-forme (46) et ladite barre (49).

4. Système de micro-ordinateur selon l'une quelconque des revendications 1 à 3, dans lequel lesdits moyens de raccord (20) à une extrémité de ceux-ci comportent pour engagement de manière amovible d'au moins une fente dans ladite paroi verticale et, à leurs extrémités opposées, des moyens (26, 27) pour engager de manière amovible le moyen le plus en haut (31, 32) des seconds moyens de connecteur femelle (12) dans une carte d'extension (11) dans ledit premier moyen de connecteur femelle (10).

5. Système de micro-ordinateur selon la revendication 4, dans lequel lesdits moyens (26, 27) pour engager de manière amovible le moyen le plus en haut desdits seconds moyens de connecteur femelle (12) comprend des premier et second moyens (31, 32) pour engager des première et seconde extrémités dudit moyen de connecteur femelle le plus en haut (12), lesdits premier et second moyens (31, 32) étant fixés de manière élastique au corps du moyen de raccord (20).

6. Système de micro-ordinateur selon l'une quelconque des revendications 1 à 5, dans lequel lesdits premier et second moyens (31, 32) pour engagement comprennent des moyens de verrouillage chacun ayant une surface en pente pour engagement initial avec le connecteur femelle le plus en haut et des moyens (12) se conformant au profil du connecteur femelle le plus en haut pour engagement un verrouillage final avec celui-ci.

7. Système de micro-ordinateur selon l'une quelconque des revendications 1 à 6, dans lequel ledit corps du raccord (20) comporte un rebord (33) adjacent audit moyen de verrouillage (31, 32) pour engager ladite carte d'extension (11) entre un bord dudit moyen de verrouillage (31, 32) et ledit rebord (33).

**Patentansprüche**

1. Mikrocomputersystem mit Mitteln zum Einsetzen zusätzlicher Adapterkarten (13), wobei diese Mittel ein erstes Sockelelement (10) aufweisen, das mit einer horizontalen, ebenen Bauteile (5) des Mikrocomputers tragenden Platte (4) verbunden und von dieser abgestützt ist, enthaltend:
   eine Verlängerungskarte (11), die in das erste Sockelelement (10) steckbar ist und von diesem gehalten werden kann, sodaß sie sich vertikal von der ebenen Platte (4) erstreckt, und die eine Mehrzahl zweiter Sockelelemente (23, 24, 25) trägt, wobei jedes zweite Sockelelement dazu eingerichtet ist, einen Kantenstrecker einer horizontal angeordneten Adapterkarte (13) aufzunehmen;
   ein Brückenelement (20), das zwischen dem oberen Ende der Verlängerungskarte (11) und einer vertikalen Wand des Mikrocomputers entfernbar montiert ist, um eine horizontale Bewegung der Verlängerungskarte (11) so gering wie möglich zu halten; und
   ein Abstützelement (18), das in einem Schlitz (41, 42) einer vertikalen Wand (17) des Mikrocomputers entfernbar montiert ist, um bei gleitender Bewegung in Eingriff mit einem Ende einer horizontal angeordneten Adapterkarte (13) zu gelangen, wobei das Abstützelement (18) einen genuteten Arm (43) besitzt, um das Ende einer Adapterkarte (13) zu umfassen und abzustützen.

2. Mikrocomputersystem nach Anspruch 1, bei welchem das Abstützelement (18) eine Platte (46) aufweist, die an einem Ende des genuteten Arms (43), senkrecht zu diesem befestigt ist, eine Verlängerung (45) mit kreisförmigem Querschnitt, die an der Platte (46), koaxial zu dem genuteten Arm (43) befestigt ist, sowie eine Leiste (49), die an dem Ende der Verlängerung (45), rechtwinkelig zu dieser befestigt ist, wobei der Durchmesser der Verlängerung (45) und die Dicke der Leiste (49) im wesentlichen der Breite der Schlitze (41, 42) entsprechen, die Länge der Leiste (49) beträchtlich größer als die Breite der Schlitze (41, 42) ist und die Länge der Verlängerung (45) im wesentlichen der Dicke der vertikalen Wand (17) entspricht, welche die Schlitze (41, 42) umgrenzt.

3. Mikrocomputersystem nach Anspruch 2, das an der Platte (46) befestigte Lappenstücke (47, 48) aufweist, wobei diese Lappenstücke (47, 48) zwecks Aufbringung einer Federkraft auf die vertikale Wand (17) den genuteten Arm (43) zwischen der Platte (46) und der Leiste (49) abstützen.

4. Mikrocomputersystem nach irgendeinem der Ansprüche 1 bis 3, bei welchem das Brückenelement (20) an einem Ende Elemente (26, 27) aufweist, um lösbar in zumindest einen Schlitz der vertikalen Wand einzugreifen, und an seinem gegenüberliegenden Ende Elemente (31, 32) aufweist, um das oberste der zweiten Sockelelemente (12) einer in dem ersten Sockelelement (10) befindlichen Verlängerungskarte (11) lösbar zu erfassen.

5. Mikrocomputersystem nach Anspruch 4, bei welchem die Elemente (26, 27) zum lösbaren Erfassen des obersten der zweiten Sockelelemente (12) erste und zweite Elemente (31, 32) zum Erfassen eines ersten und zweiten Endes des obersten Sockelelements (12) aufweisen, wobei die ersten und zweiten Elemente (31, 32) an dem Körper des Brückenelements (20) federnd angebracht sind.

6. Mikrocomputersystem nach irgendeinem der Ansprüche 1 bis 5, bei welchem die ersten und zweiten Elemente (31, 32) zum Erfassen Schnappelemente aufweisen, die je eine geneigte Fläche zum anfänglichen Angriff auf dem obersten Sockel aufweisen, sowie Elemente (12), die dem Profil des obersten Sockels entsprechen, um mit diesem in eine endgültige Verriegelung zu gelangen.

7. Mikrocomputersystem nach irgendeinem der Ansprüche 1 bis 6, bei welchem der Körper der Brücke (20) benachbart zu den Schnappelementen (31, 32) eine Stufe (33) besitzt, um die Verlängerungskarte (11) zwischen einer Kante der Schnappelemente (31, 32) und dieser Stufe (33) zu erfassen.

FIG. 1

# FIG. 2

FIG. 3

FIG. 4

FIG. 5